# FASCICULE DE BREVET EUROPEEN

(11) **EP 1 988 566 B1**
(45) Date de publication et mention de la délivrance du brevet: **02.08.2017**
(21) Numéro de dépôt: 08354025.2
(22) Date de dépôt: 28.04.2008
(51) Int. Cl.: H01L 21/033, H01L 21/308, H01L 21/768, B01D 67/00, B81C 1/00

(54) **Procédé de fabrication de motifs au sein d'une couche de polymère**
Herstellungsverfahren von Mustern in einer Polymerschicht
Method for creating patterns inside a polymer layer

(30) Priorité: 04.05.2007 FR 0703230
(43) Date de publication de la demande: 05.11.2008
(73) Titulaire: Commissariat à l'Énergie Atomique et aux Énergies Alternatives, 75015 Paris (FR)
(72) Inventeur: Gaillard, Frédéric-Xavier, 38500 Voiron (FR); VanDroux, Laurent, 38570 Le Cheylas (FR)
(74) Mandataire: Hecké, Gérard

(56) Documents cités:
- JP-A- 1 059 817
- JP-A- 64 002 008

## Description

### Domaine technique de l'invention

L'invention est relative à un procédé de fabrication d'un réseau de motifs au moyen d'un polymère déposé sur un support.

### État de la technique

Actuellement, la réalisation de motifs à l'échelle micro/nanométrique est réalisée difficilement par les procédés lithographiques conventionnels, avec insolation d'une résine.

L'utilisation d'un rayonnement UV profond (DUV, « Deep UltraViolet » en anglais), ayant atteint ses limites, cette technique a été remplacée par le rayonnement UltraViolet extrême (EUV). La réduction de la longueur d'onde du rayonnement utilisé à permis d'obtenir des motifs plus fins. Ce rayonnement (193 nm de longueur d'onde) couplé à des techniques d'amélioration de la résolution, par exemple à une correction de proximité optique (OPC « optical proximity correction » en anglais), ou a des masques à décalage de phase, PSM « phase-shift masks » en anglais) permet la réalisation de motifs dont la taille est inférieure à la longueur d'onde. Cette approche ayant également atteint ses limites, des améliorations ont été apportées sur les scanners. Ces derniers ont vu leur indice de réfraction augmenté par l'addition d'un liquide entre la résine et la lentille traversée par le rayonnement UV.

Ces perfectionnements se sont traduits par une forte augmentation du prix des équipements de lithographie et des masques. Cependant, ces procédés conventionnels lithographiques ne sont plus en mesure d'atteindre les spécifications des prochaines générations de circuits intégrés. De plus, avec l'augmentation attendue du coût des prochaines générations d'équipements lithographiques conventionnels, de nouvelles techniques sont envisagées.

La lithographie électronique (« e-beam ») est une voie qui présente, actuellement, un regain d'intérêt. La lithographie électronique consiste à insoler la résine au moyen d'un faisceau d'électrons sans utiliser de masque préalable. Ce procédé est utilisé depuis de nombreuses années pour la réalisation des masques de lithographie. Cependant, cette technique présente de nombreux inconvénients, elle ne permet pas la réalisation de forts volumes de productions et est sujette aux effets de charge. Il est également important de signaler que pour atteindre les spécifications des prochaines générations de circuits intégrés, de nouvelles résines, plus performantes, devront être développées.

L'utilisation de copolymères diblocs est également une voie d'amélioration étudiée notamment dans la demande de brevet français 0702218 déposée le 27/03/2007. Cette technique a pour principal inconvénient d'utiliser deux polymères non miscibles dont il est difficile de maîtriser la répartition spatiale. Dans ces conditions, l'utilisation de copolymères diblocs impose de travailler sous une épaisseur limite, afin d'obtenir une grande uniformité dans la taille des pores et/ou d'utiliser une couche de masque dur.

Une fois le réseau de motifs défini par toute technique connue et adaptée, la résine sert de masque de gravure pour reproduire le dessin du masque au moins au sein de la couche immédiatement en dessous. Cette gravure est, de manière classique, réalisée au moyen d'un plasma. Selon les couches en présence, les caractéristiques du plasma sont définies afin de graver la couche de support sur laquelle est placé le masque de résine.

JP 1 059817 A et JP 64 002008 A décrivent des procédés de fabrication d'un réseau de motifs au moyen d'un polymère.

### Objet de l'invention

L'objet de l'invention consiste à pallier les inconvénients précités et en particulier à réaliser des motifs au moyen d'un polymère par un procédé facile à mettre en oeuvre et moins cher à industrialiser que les technologies conventionnelles. Ce procédé doit de plus, de préférence, être compatible avec les spécifications dimensionnelles des futures générations de circuits intégrés.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 2 représentent les étapes successives d'un mode de réalisation d'un procédé selon l'invention.
La figure 3 représente une variante de l'étape de la figure 2.
Les figures 4 à 7 représentent les étapes successives d'un second mode de réalisation d'un procédé selon l'invention.
La figure 8 représente une variante de l'étape de la figure 7.
La figure 9 représente un troisième mode de réalisation.
Les figures 10 et 11 représentent les étapes successives d'un quatrième mode de réalisation d'un procédé selon l'invention.

### Description de modes particuliers de réalisation

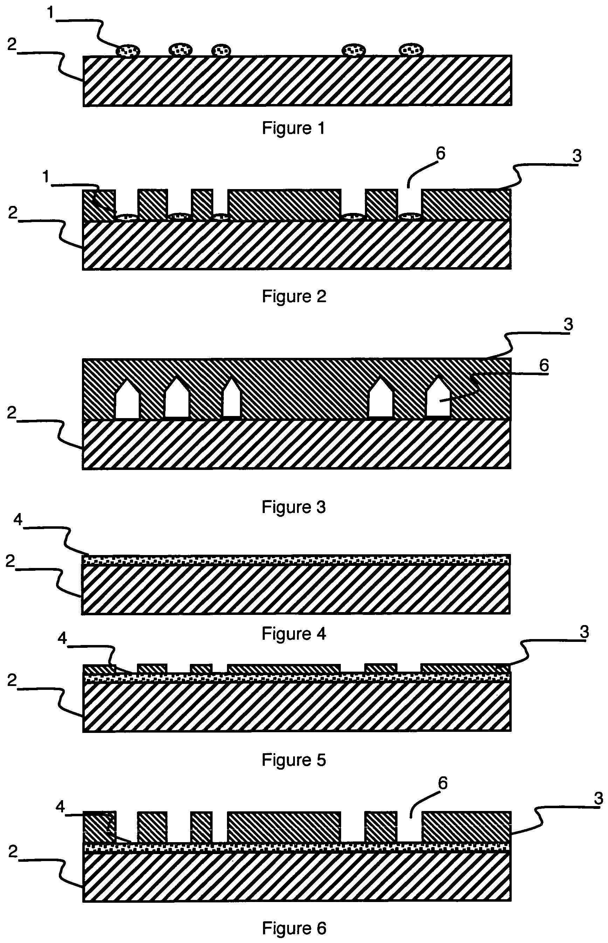

Comme illustré sur la figure 1, selon un mode particulier de réalisation, des agrégats 1 de polymère sont réalisés sur un support 2. Le support 2 est préférentiellement de type semi-conducteur et avantageusement un substrat de silicium. Le support 2 peut comporter, également, un empilement de couches réalisées, préalablement, au dépôt des agrégats 1 de polymère. Les agrégats 1 de polymères, c'est-à-dire un ensemble de molécules ou de particules, sont obtenus par exemple par le dépôt d'une goutte de matériau polymère après qu'un solvant ait été évaporé. Le polymère déposé est, par exemple, une résine à base carbonée ou, d'une manière plus générale, toute résine pouvant être éliminée au moyen d'un plasma oxydant ou réducteur. Les agrégats 1 de polymère sont déposés selon une organisation prédéfinie par tout moyen connu. Le dépôt de gouttes de polymère est avantageusement réalisé au moyen d'un équipement de type Altadrop® ou Xennia®. Les gouttes ont, par exemple, un diamètre supérieur ou égale à 10 nm et avantageusement un diamètre supérieur ou égale à 25 nm. D'autre part, le dépôt de polymère peut être réalisé par dépôt chimique en phase vapeur, et avantageusement par dépôt chimique en phase vapeur assisté par plasma et ainsi déposer par exemple du carbone amorphe.

Ensuite, comme illustré sur la figure 2, le substrat 2 et les agrégats 1 de polymère déposés sont soumis à un plasma. Le plasma peut être de type oxydant ou de type réducteur et présente des caractéristiques utilisées, de manière connue, pour effectuer le dépôt d'un matériau diélectrique 3. Le choix du type de plasma est réalisé en fonction du matériau que l'on veut déposer et/ou de la nature du polymère déposé précédemment. Par exemple, un plasma de type oxydant permettant le dépôt d'oxyde de silicium, peut être utilisé. Ce plasma peut alors comporter un précurseur du silicium et de l'oxygène, par exemple un mélange d'oxygène et de TetraEthylOxySilane (Si(OC₂H₅)₄). Avantageusement, le plasma présente les caractéristiques suivantes : une pression comprise entre 5 et 15 torr, une puissance entre 300 et 1000W, une température entre 300 et 450°C, un débit d'oxygène (O₂) entre 0,5 et 2 Slm, un débit d'hélium (He) entre 0,5 et 2 Slm, et un débit de TEOS entre 100mg/min et 2g/min. A titre d'exemple, le plasma peut présenter les caractéristiques suivantes : pression 7,5torr, puissance 380W, température 400°C, débit O₂ 2,15Slm, débit He 1Slm, débit TEOS 250mg/min. Un débit de 1Slm (1 standard liter/minute) correspond à un débit équivalent à 1 litre par minute dans les conditions standards de pression et de température. Ces caractéristiques de plasma sont celles utilisées de façon connue pour réaliser un dépôt de TEOS et peuvent éventuellement être modifiées. Dans le cas de l'utilisation d'un plasma réducteur, les matériaux déposés sont par exemple de type SiN, SiC, SiCN pour lesquels l'agent permettant de graver le polymère est l'hydrogène. L'homme du métier adaptera les conditions du procédé plasma par exemple en termes de pression, puissance, température, débit des gaz afin d'obtenir la simultanéité de la gravure et du dépôt. En effet, un ajustement des conditions du plasma (par exemple, puissance radiofréquence, flux des gaz, pression de travail, température...) peut permettre l'obtention d'un procédé adapté à chaque type de polymère et plus apte à la réalisation de l'application recherchée.

Les caractéristiques du plasma et le choix du polymère sont définis de façon à ce que le polymère présente des sites de réaction préférentielle avec le plasma et qu'un dépôt de matériau diélectrique 3 par le plasma ait alors lieu uniquement dans les zones du substrat 2 non protégées par les agrégats 1. En ce qui concerne les agrégats 1 de polymère, leur surface présente, de manière générale, une certaine densité de sites de réaction préférentielle et/ou des sites ayant un volume d'action tels que l'on peut assimiler toute ou au moins une partie de la surface de l'agrégat 1 comme réactive. En effet, il se peut que la réaction n'ait pas lieu sur toute la surface de l'agrégat 1. La réaction qui a lieu entre le polymère et le plasma empêche alors tout dépôt.

De façon générale, un agrégat 1 de polymère réagit donc avec le plasma au niveau de sites de réaction préférentielle du polymère et empêche ainsi tout dépôt de matériau diélectrique à ce niveau. Les sites de réactions préférentielles présents à la surface du polymère sont, par exemple, des zones présentant une rugosité différente du reste de la surface du polymère.

Selon la nature du polymère, les caractéristiques du plasma et la durée d'application du plasma, deux cas de figure peuvent se présenter. On choisit, préférentiellement, une durée de plasma qui n'élimine pas les agrégats 1 et/ou des conditions de plasma qui ne favorisent pas le rebouchage des cavités.

Dans une première configuration, illustré à la figure 2, le polymère est au moins partiellement éliminé par le plasma et les agrégats 1 peuvent alors disparaître du fond des ouvertures 6. Cependant, comme sur la figure 3, celles-ci ne sont pas fermées avant le dépôt d'une certaine épaisseur de matériau diélectrique, un dépôt de type non conforme étant préférentiellement choisi.

Selon l'épaisseur de matériau diélectrique 3 déposée et les conditions du plasma, les agrégats 1 de polymère sont partiellement ou totalement consommés. Dans le cas où le polymère n'a pas été complètement consommé, il peut être éliminé, a posteriori, de manière connue, par retrait sélectif par rapport au matériau diélectrique déposé. Dans une deuxième configuration, si, comme illustré à la figure 3, le dépôt est assez épais, les motifs définis par les agrégats 1 de polymère sont cachés par la surépaisseur qui rebouche le dessus des ouvertures 6. Une gravure sèche ou humide de la surépaisseur peut permettre de rendre visible les ouvertures, si nécessaire.

Il en résulte, alors, la formation d'un masque de gravure au sein de la couche de matériau diélectrique 3.

Avantageusement, dans le mode de réalisation illustré aux figures 1 à 3, les pores sont localisés de manière précise au moyen de la localisation préalable du polymère. Dans ce cas, toute la surface exposée du polymère réagit avec le plasma.

Selon un autre mode de réalisation, comme illustré sur la figure 4, une couche 4 de polymère est déposée, pleine plaque, sur le substrat 2. Cette couche 4 est de préférence mince, typiquement dans une gamme allant de 10 à 500 nm et avantageusement entre 25 et 75 nm, par exemple 50 nm afin d'obtenir des temps de procédé compatibles avec une application industrielle. Cette couche 4 de polymère est, par exemple, en carbone amorphe, déposée par tout procédé connu, par exemple, par dépôt chimique en phase vapeur assisté par plasma.

Comme illustré sur les figure 5 et 6, la couche 4 de polymère est ensuite soumise à un plasma. Le plasma est, par exemple, un plasma oxydant réalisant le dépôt de TEOS (par exemple : 7,5 torr, 380 W, 400°C, O₂ 2,15 Slm, He 1 Slm, TEOS 250mg/min). La nature de la couche 4, ses conditions de dépôt ainsi que les conditions du plasma sont définies de telle sorte que le polymère comporte en surface des sites de réaction préférentielle au plasma et des sites où la réactivité au plasma est nulle ou négligeable par rapport aux sites de réaction préférentielle. La densité de sites de réaction préférentielle est fonction de la nature du polymère, de son procédé de dépôt ainsi que des caractéristiques du plasma.

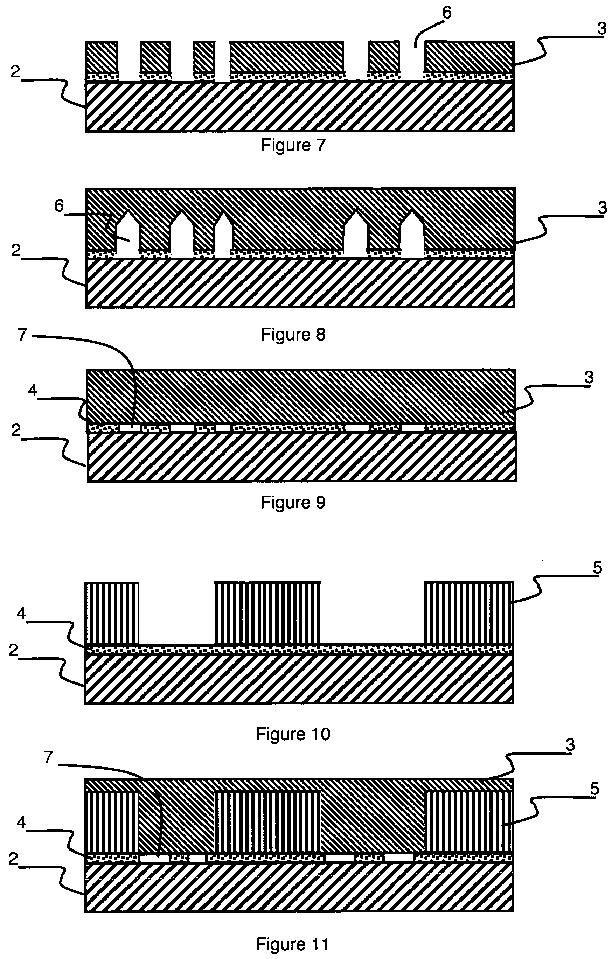

Selon les conditions du plasma, ce dernier réagit en empêchant le dépôt de matériau diélectrique 3 sur les sites de réaction préférentielle, comme illustré sur les figures 5 et 6. Il en résulte, au fur et à mesure du dépôt par plasma, un dépôt uniquement sur le polymère dans les zones ne contenant pas de sites de réaction préférentielle. Comme précédemment, des ouvertures 6, correspondant aux zones caractérisées par une absence de dépôt, constituent ainsi un réseau de motifs au sein du matériau diélectrique 3. L'absence de dépôt au-dessus des sites de réaction préférentielle peut être concomitant avec une consommation du polymère de la couche 4 dans les sites de réaction préférentielle (figure 7). Dans ce cas, le réseau de motifs est formé à la fois dans la couche de matériau diélectrique 3 et dans la couche 4 de polymère. Selon les conditions du plasma et la nature du polymère déposé, les sites de réaction préférentielle au sein de couche de polymère peuvent être assimilés, par exemple, à des variations de la rugosité ou de la nature du matériau c'est-à-dire à des variations locales de sa stoechiométrie.

Comme mentionné précédemment et illustré sur la figure 8, l'épaisseur de matériau diélectrique déposé peut être suffisante pour fermer les ouvertures 6 à leur extrémité supérieure (que le polymère soit complètement consommé ou non). Il est alors possible de redécouvrir le réseau de motifs en réalisant par exemple un polissage mécano-chimique ou alors par une gravure physique ou humide de la partie supérieure de la couche 3 de matériau diélectrique déposée.

Dans certaines conditions, la couche 4 de polymère ayant été complètement éliminée, un dépôt fin de diélectrique peut alors apparaître dans le bas de la cavité. En effet une fois la couche 4 éliminée, le dépôt de diélectrique dans la cavité est alors possible. Une attention particulière sera donc apportée aux conditions de dépôt du diélectrique de manière à ce que ce dernier soit dit « non conforme », c'est-à-dire qu'il pérennise la topographie existante au sein de la couche 3 de diélectrique. Ainsi des cavités d'air sont formées au sein de la couche 3 de diélectrique, la cavité pouvant être bordée uniquement de diélectrique

Dans les cas précédents, la couche 3 de diélectrique est utilisée comme masque c'est-à-dire que la couche 3 de diélectrique comporte l'essentiel de la topographie du motif.

Selon un autre mode de réalisation, illustré par la figure 9, le polymère constituant la couche 4, la nature et les conditions du dépôt de la couche 3 sur la couche 4 ainsi que les conditions du plasma sont définies de telle sorte que le polymère comporte en surface des sites de réaction préférentielle au plasma tels que le plasma réagisse avec ces sites en éliminant le polymère. Avantageusement, la couche 4 en matériau polymère est choisie avec une épaisseur plus importante que dans les autres modes de réalisation. Il en résulte alors, au fur et à mesure du dépôt par plasma, une élimination de la couche 4 de polymère dans les sites de réaction préférentielle. De cette manière, dans ce mode de réalisation, le réseau de motifs est alors essentiellement, voire uniquement, formé dans la couche 4 de polymère. Les ouvertures 7 formées dans la couche 4 sont ensuite recouvertes, comme le reste de la couche 4, par le matériau diélectrique 3. Alors que dans les cas précédents, la couche de diélectrique 3 contient essentiellement la topographie liée à la réaction entre le plasma et le polymère 4, dans ce cas de figure, la topographie est essentiellement située au sein de la couche 4 en polymère.

Un quatrième mode de réalisation, illustré sur la figure 10, représente une variante du mode de réalisation, de la figures 9, où une étape supplémentaire est ajoutée entre le dépôt de la couche 4 de polymère et le dépôt par plasma. Dans cette étape supplémentaire, une couche supplémentaire 5 est déposée et gravée selon un motif prédéfini, elle permet de masquer des zones dans lesquelles la réaction de la couche 4 de polymère avec le plasma n'est pas recherchée. Il est ainsi possible de former le réseau de motifs uniquement dans les zones de la couche 4 non recouvertes par la couche supplémentaire 5. Cette étape supplémentaire peut également être introduite dans les modes de réalisation des figures 1 à 8.

Le réseau de motifs réalisé au moins au sein de la couche de matériau diélectrique 3 peut être utilisé en tant que masque de gravure pour définir un nouveau réseau de motifs au sein du support 2 ou de toute couche située sous la couche de matériau diélectrique 3. Le transfert du réseau de motifs à travers le matériau diélectrique peut être réalisé, de manière connue, par une gravure humide ou au moyen d'une gravure plasma. De même, une couche additionnelle servant de masque dur peut être utilisée pour faciliter les étapes de gravure.

Ce procédé de fabrication peut être utilisé, par exemple, pour la réalisation de structures d'interconnexion avec des cavités d'air ou alors pour la réalisation de membranes poreuses pour les biotechnologies. Les ouvertures 6, 7 peuvent par exemple constituer des canaux lorsque les gouttes 1 de polymère sont alignées (figures 1 à 3) ou lorsque les zones contenant les sites de réaction préférentielle ont la forme correspondante.

La réalisation d'une membrane poreuse peut être particulièrement avantageuse selon le mode de réalisation illustré aux figures 4 à 6. En effet, seuls les sites préférentiels sont exposés et on obtient avantageusement une répartition uniforme des pores en particulier des petits pores de diamètre inférieure à 50nm.

## Revendications

1. Procédé de fabrication d'un réseau de motifs au moyen d'un polymère (1,4) déposé sur un support (2), ce procédé comportant successivement :
- former sur le support (2) des sites de polymère qui réagissent préférentiellement avec un plasma prédéterminé, en empêchant le dépôt d'un matériau diélectrique par ledit plasma sur lesdits sites,
- déposer, sur le support (2), un matériau diélectrique (3) par ledit plasma, les sites de polymère réagissant avec le plasma en empêchant le dépôt du matériau diélectrique au niveau desdits sites, de manière à former des ouvertures (6, 7) au niveau desdits sites.

2. Procédé selon la revendication 1, dans lequel la formation desdits sites de polymère est réalisée par le dépôt pleine plaque du polymère, le polymère présentant des sites de réaction préférentielle et des zones non réactives audit plasma.

3. Procédé selon la revendication 1, dans lequel lesdits sites de polymère sont formés par dépôt d'agrégats (1) de polymère sur le support (2), la disposition desdits agrégats correspondant au réseau de motifs désiré.

4. Procédé selon l'une quelconque des revendications 1 à 3, dans lequel lesdites ouvertures (6) sont formées dans le matériau diélectrique face aux sites.

5. Procédé selon l'une quelconque des revendications 1 à 4, dans lequel lesdites ouvertures (7) sont formées dans le polymère.

6. Procédé selon l'une quelconque des revendications 1 à 5, dans lequel le plasma est de type oxydant

7. Procédé selon l'une quelconque des revendications 1 à 5, dans lequel le plasma est de type réducteur.

8. Procédé selon l'une quelconque des revendications 1 à 7, dans lequel le polymère est du carbone amorphe.

9. Procédé selon l'une quelconque des revendications 1 à 8, dans lequel lesdits sites réactifs sont constitués par des zones de rugosité différente du reste de la surface du polymère et/ou des zones de stoechiométrie différente par rapport à la composition globale moyenne.

10. Procédé selon l'une quelconque des revendications 1 à 9, dans lequel le plasma étant de type oxydant, le matériau diélectrique déposé est de l'oxyde de silicium.

11. Procédé selon l'une quelconque des revendications 1 à 9, dans lequel le plasma étant de type réducteur, le matériau diélectrique déposé est du SiCN ou du SiC ou du SiN.

## Patentansprüche

1. Verfahren zur Herstellung eines Netzes aus Mustern mittels eines Polymers (1, 4), das auf einem Träger (2) abgeschieden wird, wobei dieses Verfahren nacheinander umfasst:
- Ausbilden - auf dem Träger (2) - von Polymerstellen, die vorzugsweise mit einem vorbestimmten Plasma, unter Verhindern der Abscheidung eines dielektrischen Materials durch das Plasma an den Stellen, reagieren,
- Abscheiden eines dielektrischen Materials (3) durch das Plasma auf dem Träger (2), wobei die Polymerstellen, unter Verhindern der Abscheidung des dielektrischen Materials im Bereich der Stellen, mit dem Plasma reagieren, um Öffnungen (6, 7) im Bereich der Stellen zu bilden.

2. Verfahren nach Anspruch 1, bei dem die Bildung der Polymerstellen durch das vollflächige Abscheiden des Polymers vollzogen wird, wobei das Polymer bevorzugte Reaktionsstellen und nicht plasmareaktive Bereiche aufweist.

3. Verfahren nach Anspruch 1, bei dem die Polymerstellen durch Abscheidung von Anhäufungen (1) von Polymer auf dem Träger (2) gebildet werden, wobei die Anordnung der Anhäufungen dem gewünschten Musternetz entspricht.

4. Verfahren nach einem der Ansprüche 1 bis 3, bei dem die Öffnungen (6) in dem dielektrischen Material gegenüber den Stellen ausgebildet werden.

5. Verfahren nach einem der Ansprüche 1 bis 4, bei dem die Öffnungen (7) in dem Polymer ausgebildet werden.

6. Verfahren nach einem der Ansprüche 1 bis 5, bei dem das Plasma vom oxidierenden Typ ist.

7. Verfahren nach einem der Ansprüche 1 bis 5, bei dem das Plasma vom reduzierenden Typ ist.

8. Verfahren nach einem der Ansprüche 1 bis 7, bei dem das Polymer amorpher Kohlenstoff ist.

9. Verfahren nach einem der Ansprüche 1 bis 8, bei dem die reaktiven Stellen durch Bereiche mit von der restlichen Oberfläche des Polymers verschiedener Rauigkeit und/oder Bereiche mit gegenüber der durchschnittlichen Gesamtzusammensetzung verschiedener Stöchiometrie gebildet sind.

10. Verfahren nach einem der Ansprüche 1 bis 9, bei dem, wenn das Plasma vom oxidierenden Typ ist, das abgeschiedene dielektrische Material Siliziumoxid ist.

11. Verfahren nach einem der Ansprüche 1 bis 9, bei dem, wenn das Plasma vom reduzierenden Typ ist, das abgeschiedene dielektrische Material SiCN oder SiC oder SiN ist.

## Claims

1. A method for producing a pattern structure by means of a polymer (1,4) deposited on a support (2), such method successively comprising:
- forming, on the support (2), polymer sites which preferably react with a predetermined plasma, by preventing the deposit of a dielectric material by said plasma on said sites,
- depositing, on the support (2), a dielectric material (3) by said plasma, the polymer sites reacting with the plasma by preventing the deposit of the dielectric material at the level of said sites, so as to form openings (6,7) at the level of said sites.

2. The method according to claim 1, wherein the formation of said polymer sites is achieved by full-wafer deposition of the polymer, the polymer presenting preferential reaction sites and zones that are not reactive to said plasma.

3. The method according to claim 1, wherein said polymer sites are formed by depositing polymer aggregates (1) on the support (2), the arrangement of said aggregates corresponding to the required pattern structure.

4. The method according to any one of claims 1 to 3, wherein said openings (6) are formed in the dielectric material facing the sites.

5. The method according to any one of claims 1 to 4, wherein said openings (7) are formed in the polymer.

6. The method according to any one of claims 1 to 5, wherein the plasma is of oxidizing type.

7. The method according to any one of claims 1 to 5, wherein the plasma is of reducing type.

8. The method according to any one of claims 1 to 7, wherein the polymer is amorphous carbon.

9. The method according to any one of claims 1 to 8, wherein said reactive sites are formed by zones of different roughness from the rest of the surface of the polymer and/or zones of different stoichiometry with respect to the mean global composition.

10. The method according to any one of claims 1 to 9, wherein the plasma being of oxidizing type, the dielectric material deposited is silicon oxide.

11. The method according to any one of claims 1 to 9, wherein the plasma being of reducing type, the dielectric material deposited is SiCN or SiC or SiN.
